# EUROPÄISCHE PATENTANMELDUNG

(11) **EP 1 227 709 A2**
(43) Veröffentlichungstag der Anmeldung: **31.07.2002**
(21) Anmeldenummer: 01129510.2
(22) Anmeldetag: 11.12.2001
(51) Int. Cl.: H05K 3/04, H01L 21/48

(54) **Verfahren zur Herstellung von Leiterbahnstrukturen**

(30) Priorität: 24.01.2001 DE 10103193
(71) Anmelder: W.C. Heraeus GmbH & Co. KG, 63450 Hanau (DE)
(72) Erfinder: Bauer, Alfred, 63755 Alzenau (DE); Hartmann, Horst, 63454 Hanau (DE); Kolodzei, Günter, 63791 Karlstein (DE)
(74) Vertreter: Kühn, Hans-Christian

(57) **Zusammenfassung**

Die Erfindung betrifft ein Verfahren zur Herstellung von Leiterbahnstrukturen in einem langgestreckten Materialband, wobei eine einzelne Leiterbahnstruktur aus einem ersten Stanzbild und einem zweiten Stanzbild gebildet wird, wobei das erste Stanzbild durch mindestens einen ersten Stanzschritt an mindestens einer ersten Stanzstation und das zweite Stanzbild durch mindestens einen weiteren Stanzschritt an mindestens einer weiteren Stanzstation erzeugt wird. Es stellt sich das Problem, ein Stanzverfahren zur Herstellung von Leiterbahnstrukturen beziehungsweise Stanzbildern bereitzustellen. Das Problem wird dadurch gelöst, dass das erste und das zweite Stanzbild sich teilweise überschneiden.

## Beschreibung

Die Erfindung betrifft ein Verfahren zur Herstellung von Leiterbahnstrukturen in einem langgestreckten Materialband, wobei eine einzelne Leiterbahnstruktur aus einem ersten Stanzbild und einem zweiten Stanzbild gebildet wird, wobei das erste Stanzbild durch mindestens einen ersten Stanzschritt an mindestens einer ersten Stanzstation und das zweite Stanzbild durch mindestens einen weiteren Stanzschritt an mindestens einer weiteren Stanzstation erzeugt wird. Des weiteren betrifft die Erfindung die Verwendung einer so erzeugten Leiterbahnstruktur und die Verwendung eines Folgewerkzeugs.

Gattungsgemäß offenbart DE 37 03 649 A1 ein Werkzeug in Modulbauweise zum Stanzen von komplexen Stanzbildern aus einem Metallband, mit welchem die Herstellung der Stanzbilder in mehreren aufeinanderfolgenden Stanzschritten erfolgt. Durch die Modulbauweise können bei Änderung des Stanzbildes oder bei störanfälligen Stanzbildern im Rahmen von Wartungsarbeiten oder Störungen einzelne Module schnell ausgetauscht werden.

DE 195 21 022 A1 beschreibt ein Verfahren zur Herstellung eines Schichtverbundes aus mindestens zwei Folienbahnen. Dabei wird jede Folienbahn in einer Stanzvorrichtung mit sich in gleichen Abständen widerholenden Stanzstrukturen versehen und die Folienbahnen anschließend miteinander verklebt. Um die Folienbahnen passgenau zueinander positionieren und verkleben zu können, werden in die Folienbahnen identische Positionsmarkierungen gestanzt. Nach dem Ausrichten der Folienbahnen anhand dieser Positionsmarkierungen und vor einem ganzflächigen Verkleben werden Heftpunkte angebracht, um Summenfehler durch die unterschiedlichen Wärmedehnungen der Folienbahnen zu verhindern.

SU 1438886 offenbart ein Stanzverfahren für Metallbänder, bei dem zuerst Reihen von Öffnungen in ein Metallband gestanzt werden und anschließend jeweils zwei dieser Öffnungen, die benachbart zueinander angeordnet sind, durch einen Schnitt miteinander verbunden werden. Zwischen den so verbundenen Öffnungen liegende Metallbandteile, die klappen- oder flügelartige Form aufweisen, werden durch Knicken beziehungsweise Biegen verformt und die Öffnungen damit vergrößert.

Es stellt sich das Problem, ein weiteres Stanzverfahren zur Herstellung von Leiterbahnstrukturen beziehungsweise Stanzbildern bereitzustellen, eine Verwendung des Stanzverfahrens und eine Verwendung für ein durch einen Programmgeber angesteuertes Folgewerkzeug anzugeben.

Das Problem wird dadurch gelöst, dass das erste und das zweite Stanzbild sich teilweise überschneiden. Unter einem Stanzbild werden dabei alle in mindestens einem Stanzschritt erzeugten, sich jedoch gegenseitig nicht berührenden oder überschneidenden Öffnungen im Materialband verstanden. So kann das erste Stanzbild wie auch das zweite Stanzbild jeweils in mehreren nacheinanderfolgenden Stanzschritten gebildet sein.
Erfindungsgemäß bedeutet nun eine teilweise Überschneidung des ersten und des zweiten Stanzbildes, dass Öffnungen des ersten Stanzbildes durch Öffnungen des zweiten Stanzbildes in irgendeiner Art und Weise weitergeführt werden beziehungsweise dass Öffnungen des ersten Stanzbildes durch Öffnungen des zweiten Stanzbildes vergrößert werden.
Durch ein solches Verfahren ist die Bildung einer sogenannten "Produktfamilie" für Leiterbahnstrukturen möglich, die dadurch gekennzeichnet ist, dass eine Leiterbahnstruktur in bestimmten Bereichen mit immer gleichen Öffnungen versehen ist ( = Familienkennzeichen ) und in daran angrenzenden Bereichen mit unterschiedlichen Öffnungen gestaltet ist.
Für einen solchen Mehrfach-Stanzvorgang, bei dem die Ausbildung der Leiterbahnstruktur in mindestens zwei zeitlich aufeinander folgenden Hüben von unterschiedlichen Stanzstempeln erfolgt, können sogenannte Folgewerkzeuge in modularer oder kompakter Ausführung eingesetzt werden. Zu einem kompakten Folgewerkzeug gehören mehrere übereinander angeordnete Platten, Grundplatte, Matrizenhalteplatte, Führungsplatte, Stempelhalteplatte und Kopfplatte. Diese Platten werden mit Führungssäulen zu einem Werkzeug verbunden. Positionierstempel, Schnitteinsätze und Stanzstempel werden durch die Platten und Säulen geführt und gestützt.

Ein modulares Folgewerkzeug ist aus mehreren solchen kompakten Folgewerkzeugen aufgebaut, wobei diese in einem Grundgestell mit eigenen Führungssäulen positionsgenau befestigt sind.

Unter einer Stanzstation wird dabei ein Abschnitt des Folgewerkzeugs verstanden, an dem sich ein Stanzstempel oder eine Gruppe von Stanzstempeln befindet. Die Stanzstempel des hier vorzugsweise verwendeten Folgewerkzeugs können gesondert über einen Programmgeber angesteuert beziehungsweise betätigt werden.

Gerade in der Herstellung von Leiterbahnstrukturen für Chipmodule von "Smart Cards" (= Kreditkarten, Telefonkarten, Geldkarten usw.), wo ähnliche Leiterbahnstrukturen mit jeweils geringfügigen Änderungen zur Anpassung an den aufzunehmenden Chip hergestellt werden müssen, ist dieses Verfahren von besonderem Vorteil. Durch die Herstellung einer im Endzustand einheitlichen Leiterbahnstruktur durch zwei sich teilweise überschneidende Stanzbilder wird eine hohe Flexibilität erreicht und die Werkzeugkosten niedrig gehalten, da nur für den geringfügig geänderten Teil der Leiterbahnstruktur neue Stanzstempel hergestellt und in das Folgewerkzeug eingebaut werden müssen. Ähnlich vorteilhaft ist das Verfahren auch bei der Herstellung von Antennen für Mobiltelefone.

Das langgestreckte Materialband kann aus Metall, Kunststoff oder aus einem Metall-Kunststoff-Verbund gebildet sein. Unter einem Metall-Kunststoff-Verbund wird dabei eine Stapelanordnung von langgestreckten Metall- und Kunststofffolien unbestimmter Anzahl verstanden, die fest miteinander verbunden sind. Diese Verbindung zwischen den Folien wird meist durch Klebstoffe erreicht, wobei auch ein Klebstoff hier als Kunststoff zu behandeln ist.
Vorteilhaft ist es, wenn das langgestreckte Materialband mit einer Dicke im Bereich von 0.025 mm bis 0.6 mm verwendet wird. Leiterbahnstrukturen aus einem Materialband solcher Dicke sind hervorragend in Vertiefungen von Chipkarten, die üblicherweise eine Dicke von 0.8 mm aufweisen, einsetzbar.

Um in jedem Fall eine Überschneidung des ersten mit dem zweiten Stanzbild zu erreichen, sollte beim Stanzen im Bereich der Überschneidung von erstem und zweitem Stanzbild eine Ausbuchtung im ersten und/oder zweiten Stanzbild erzeugt werden. Wird zum Beispiel als Bestandteil eines ersten Stanzbildes eine rechteckige Öffnung gestanzt, an deren einen Ende das zweite Stanzbild überschneidend anschließen soll, so wird an der rechteckigen Öffnung eine Ausbuchtung vorgesehen. Die Ausbuchtung wird so ausgebildet, dass die Breite der Öffnung im Bereich der Überlappung vergrößert ist. Dies kann dadurch verwirklicht werden, dass das Ende der Öffnung beispielsweise mit einem kreisförmigen oder quadratischen Abschluss hergestellt wird, wobei der Durchmesser der den Abschluss bildenden Kreisöffnung größer ist oder die Breite des den Abschluss bildenden Quadrates breiter ist, als die Breite der rechteckigen Öffnung.
So wird vermieden, dass in den Überschnittsbereichen dünne Materialstege oder -reste des Materialbandes verbleiben, die zu unerwünschten elektrischen Verbindungen oder Kurzschlüssen führen können.

Das Verfahren wird kostengünstig durchgeführt, indem nach dem Stanzen des ersten Stanzbildes an mindestens der ersten Stanzstation, die einen ersten Stanzstempel oder eine erste Gruppe von Stanzstempeln aufweist, und des zweiten Stanzbildes an mindestens der weiteren Stanzstation, die einen weiteren Stanzstempel oder eine weitere Gruppe von Stanzstempeln aufweist, mindestens die eine weitere Stanzstation gegen mindestens eine andere Stanzstation mit einem anderen Stanzstempel oder einer anderen Gruppe von Stanzstempeln ausgetauscht wird, und dass nach dem Austausch ein zweites Materialband an mindestens der ersten Stanzstation, die den ersten Stanzstempel oder die erste Gruppe von Stanzstempeln aufweist, und mindestens der anderen Stanzstation, die den anderen Stanzstempel oder die andere Gruppe von Stanzstempeln aufweist, gestanzt wird.
Unter einem "Austausch" einer Stanzstation wird hier verstanden, dass entweder ein Teil des Folgewerkzeuges gegen einen anderen Teil ausgetauscht wird oder dass in dem für dieses Verfahren vorzugsweise verwendeten Folgewerkzeug, bei dem die Stanzstempel gesondert über einen Programmgeber angesteuert beziehungsweise betätigt werden können, anstelle der mindestens einen weiteren Stanzstation mindestens die eine andere Stanzstation, die vorher nicht angesteuert wurde aber bereits vorhanden war, angesteuert und damit betätigt wird. Dabei ist zu bemerken, dass die andere Gruppe von Stanzstempeln teilweise aus Stanzstempeln der weiteren Stanzstation bestehen kann.

Das Problem wird des weiteren durch die Verwendung des Verfahrens zur Herstellung einer Leiterbahnstruktur für ein Chipkartenmodul beziehungsweise ein IC-Kartenmodul gemäß ISO 7816-2 oder für eine Antenne eines Mobiltelefons gelöst. Dabei gibt die ISO 7816-2 den Standard an, wie die Anordnung der Kontakte für IC-Karten erfolgen muss und die Dimensionen der Kontakte mindestens auszubilden sind. Es handelt sich bei solchen Leiterbahnstrukturen, die je nach Dicke des verwendeten Materialbandes beispielsweise mit dünnen Materialstegen bis herab zu ca. 0.15 mm Breite oder feinen Schlitzen im Bereich von ca. 0.12 mm Breite hergestellt werden, um Massenartikel, die mit möglichst geringen Fertigungs- und Rüstzeiten sowie Werkzeugkosten hergestellt werden müssen, um preislich wettbewerbsfähig zu sein. Aufgrund der Feinheit der Leiterbahnstrukturen ist es hier besonders wichtig, die Überschneidungsbereiche der Stanzbilder exakt und vollständig auszubilden.

Das Problem wird des weiteren durch die Verwendung eines Folgewerkzeuges, dessen Stanzstempel gesondert über einen Programmgeber angesteuert beziehungsweise betätigt werden können, zur Herstellung einer Leiterbahnstruktur für ein Chipkartenmodul beziehungsweise ein IC-Kartenmodul gemäß ISO 7816-2 oder für eine Antenne eines Mobiltelefons gelöst.

Zur beispielhaften Veranschaulichung des erfindungsgemäßen Verfahrens sind nachfolgende Figuren 1a bis 2b dargestellt. So zeigt
Fig. 1a Leiterbahnstrukturen für Chipkartenmodule ( Produktfamilie A )
Fig. 1b weitere Leiterbahnstrukturen für Chipkartenmodule ( Produktfamilie A)
Fig. 2a Leiterbahnstrukturen für Antennen von Mobiltelefonen ( Produktfamilie B )
Fig. 2b weitere Leiterbahnstrukturen für Antennen von Mobiltelefonen ( Produktfamilie B )

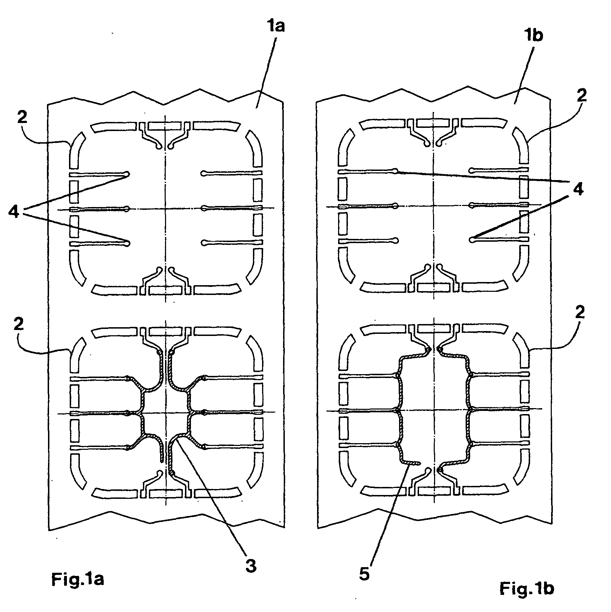

In den Figuren 1a und 1b ist jeweils ein Ausschnitt aus einem Materialband gezeigt, wobei jeweils nur eine Darstellung für ein erstes Stanzbild und ein erstes Stanzbild in Kombination mit einem zweiten Stanzbild aufgezeigt ist.

Fig. 1a zeigt ein langgestrecktes Materialband 1a aus Metall, vorzugsweise aus Kupfer. In Längsrichtung des Materialbandes 1a werden an mindestens einer ersten Stanzstation erste Stanzbilder 2 erzeugt. Danach werden an mindestens einer weiteren Stanzstation zweite Stanzbilder 3 ( schraffiert dargestellt ) erzeugt, die sich jeweils mit einem der ersten Stanzbilder 2 teilweise überschneiden. Im Bereich der Überschneidungen wurden die ersten Stanzbilder 2 mit kreisförmigen Ausbuchtungen 4 hergestellt, damit die Bereiche an mindestens der weiteren Stanzstation auch zu 100% Wahrscheinlichkeit getroffen werden.

Fig. 1b zeigt ebenfalls ein langgestrecktes Materialband 1b aus Metall. In Längsrichtung des Materialbandes 1b werden an mindestens der ersten Stanzstation, die identisch zur ersten Stanzstation aus Fig. 1a ist, erste Stanzbilder 2 erzeugt. Danach werden an mindestens einer anderen Stanzstation, die andere Stanzstempel aufweist als die weitere Stanzstation in Fig. 1a, zweite Stanzbilder 5 ( schraffiert dargestellt ) erzeugt, die sich jeweils mit einem der ersten Stanzbilder 2 teilweise überschneiden. Im Bereich der Überschneidungen wurden die ersten Stanzbilder 2 mit Ausbuchtungen 4 hergestellt, damit auch hier die Bereiche an der anderen Stanzstation zu 100% Wahrscheinlichkeit getroffen werden.

Im Vergleich der Figuren 1a und 1b ist zu erkennen, dass durch den Austausch der weiteren Stanzstation unterschiedliche Leiterbahnstrukturen erzeugt wurden, obwohl das erste Stanzbild 2 in beiden Figuren gleich war. Somit zeigen die Figuren 1a und 1b Leiterbahnstrukturen derselben Produktfamilie A.

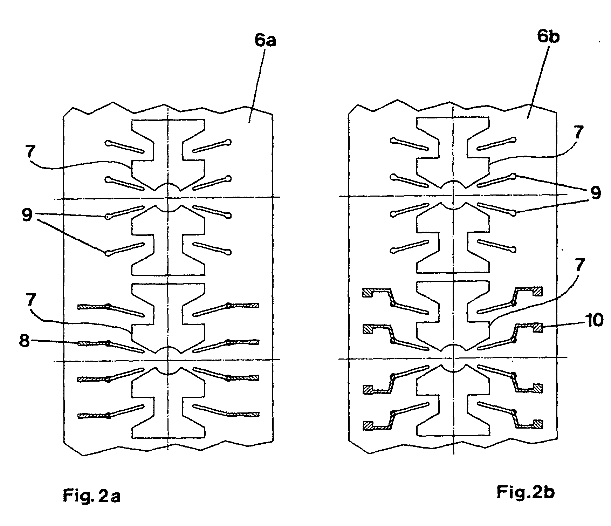

In den Figuren 2a und 2b ist jeweils ein Ausschnitt aus einem Materialband gezeigt, wobei jeweils nur eine Darstellung für ein erstes Stanzbild und ein erstes Stanzbild in Kombination mit einem zweiten Stanzbild aufgezeigt ist.

Fig. 2a zeigt ein langgestrecktes Materialband 6a aus einem Metall-Kunststoff-Verbund. In Längsrichtung des Materialbandes 6a werden an mindestens einer ersten Stanzstation erste Stanzbilder 7 erzeugt. Danach werden an einer weiteren Stanzstation zweite Stanzbilder 8 ( schraffiert dargestellt ) erzeugt, die sich jeweils mit einem der ersten Stanzbilder 7 teilweise überschneiden. Im Bereich der Überschneidungen wurden die ersten Stanzbilder 7 mit kreisförmigen Ausbuchtungen 9 hergestellt, damit die Bereiche an der weiteren Stanzstation auch zu 100% Wahrscheinlichkeit getroffen werden.

Fig. 2b zeigt ebenfalls ein langgestrecktes Materialband 6b. In Längsrichtung des Materialbandes 6b werden an mindestens der ersten Stanzstation, die identisch zur ersten Stanzstation aus Fig. 2a ist, erste Stanzbilder 7 erzeugt. Danach werden an einer anderen Stanzstation, die andere Stanzstempel aufweist als die weitere Stanzstation in Fig. 2a, zweite Stanzbilder 10 ( schraffiert dargestellt ) erzeugt, die sich jeweils mit einem der ersten Stanzbilder 7 teilweise überschneiden. Im Bereich der Überschneidungen wurden die ersten Stanzbilder 7 mit Ausbuchtungen 9 hergestellt, damit auch hier die Bereiche an der anderen Stanzstation zu 100% Wahrscheinlichkeit getroffen werden.

Im Vergleich der Figuren 2a und 2b ist zu erkennen, dass durch den Austausch der weiteren Stanzstation unterschiedliche Leiterbahnstrukturen erzeugt wurden, obwohl das erste Stanzbild 7 in beiden Figuren gleich war. Somit zeigen die Figuren 2a und 2b Leiterbahnstrukturen derselben Produktfamilie B.

## Patentansprüche

1. Verfahren zur Herstellung von Leiterbahnstrukturen in einem langgestreckten Materialband, wobei eine einzelne Leiterbahnstruktur aus einem ersten Stanzbild und einem zweiten Stanzbild gebildet wird, wobei das erste Stanzbild durch mindestens einen ersten Stanzschritt an mindestens einer ersten Stanzstation und das zweite Stanzbild durch mindestens einen weiteren Stanzschritt an mindestens einer weiteren Stanzstation erzeugt wird, **dadurch gekennzeichnet, dass** das erste und das zweite Stanzbild sich teilweise überschneiden.

2. Verfahren nach Anspruch 1, **dadurch gekennzeichnet, dass** das langgestreckte Materialband aus Metall oder Kunststoff gebildet wird.

3. Verfahren nach Anspruch 1, **dadurch gekennzeichnet, dass** das langgestreckte Materialband aus einem Metall-Kunststoff-Verbund gebildet wird.

4. Verfahren nach einem der Ansprüche 1 bis 3, **dadurch gekennzeichnet, dass** das langgestreckte Materialband mit einer Dicke im Bereich von 0.025 mm bis 0.6 mm verwendet wird.

5. Verfahren nach einem der Ansprüche 1 bis 4, **dadurch gekennzeichnet, dass** beim Stanzen im Bereich der Überschneidung von erstem und zweitem Stanzbild eine Ausbuchtung im ersten und/oder zweiten Stanzbild erzeugt wird.

6. Verfahren nach einem der Ansprüche 1 bis 5, **dadurch gekennzeichnet, dass** nach dem Stanzen des ersten Stanzbildes an mindestens der ersten Stanzstation, die einen ersten Stanzstempel oder eine erste Gruppe von Stanzstempeln aufweist, und des zweiten Stanzbildes an mindestens der weiteren Stanzstation, die einen weiteren Stanzstempel oder eine weitere Gruppe von Stanzstempeln aufweist, mindestens die eine weitere Stanzstation gegen mindestens eine andere Stanzstation mit einem anderen Stanzstempel oder einer anderen Gruppe von Stanzstempeln ausgetauscht wird, und dass nach dem Austausch ein zweites Materialband an mindestens der ersten Stanzstation, die den ersten Stanzstempel oder die erste Gruppe von Stanzstempeln aufweist, und mindestens der anderen Stanzstation, die den anderen Stanzstempel oder die andere Gruppe von Stanzstempeln aufweist, gestanzt wird.

7. Verwendung des Verfahrens nach einem der Ansprüche 1 bis 6 zur Herstellung einer Leiterbahnstruktur für ein Chipkartenmodul beziehungsweise ein IC-Kartenmodul gemäß ISO 7816-2.

8. Verwendung des Verfahrens nach einem der Ansprüche 1 bis 6 zur Herstellung einer Leiterbahnstruktur für eine Antenne eines Mobiltelefons.

9. Verwendung eines Folgewerkzeuges, dessen Stanzstempel gesondert über einen Programmgeber angesteuert beziehungsweise betätigt werden können, zur Herstellung einer Leiterbahnstruktur für ein Chipkartenmodul beziehungsweise ein IC-Kartenmodul nach ISO 7816-2 gemäß dem Verfahren nach einem der Ansprüche 1 bis 6.

10. Verwendung eines Folgewerkzeuges, dessen Stanzstempel gesondert über einen Programmgeber angesteuert beziehungsweise betätigt werden können, zur Herstellung einer Leiterbahnstruktur für eine Antenne eines Mobiltelefons gemäß dem Verfahren nach einem der Ansprüche 1 bis 6.
